# EUROPÄISCHE PATENTANMELDUNG

(11) **EP 1 406 148 A2**
(43) Veröffentlichungstag der Anmeldung: **07.04.2004**
(21) Anmeldenummer: 03019378.3
(22) Anmeldetag: 27.08.2003
(51) Int. Cl.: G06F 1/20

(54) **Hochflexible Kühlluftführung**

(30) Priorität: 03.09.2002 DE 10240641
(71) Anmelder: Fujitsu Siemens Computers GmbH, 81739 München (DE)
(72) Erfinder: Neukam, Wilhelm, 86399 Bobingen (DE); Weishaupt, Werner, 86497 Horgau (DE)
(74) Vertreter: Epping Hermann & Fischer

(57) **Zusammenfassung**

Hochflexible Kühlluftführung (1) in einem Computer zur Kühlung eines wärmeerzeugenden Bauteils (5), wobei die Kühlluftführung U-förmig ausgebildet ist und in alle Raumrichtungen beweglich ist.

## Beschreibung

Die Erfindung betrifft eine hochflexible Kühlluftführung in einem Computer, zur Kühlung eines wärmeerzeugenden Bauteils, wie einem Prozessor, welche Kühlluft zwischen einem Kühlluftein- bzw. -auslaß über ein bewegliches Element zu dem wärmeerzeugenden Bauteil leitet.

Die Leistung der in Computern verwendeten Bauteilen steigt immer mehr an. Bei vielen Komponenten wie z.B. dem Prozessor ist eine obere Leistungsgrenze oft durch die Erwärmung des Bauteils gegeben. Mit größerer Leistung wird somit auch immer ein höherer Anspruch an die Kühlung der einzelnen Bauteile gestellt.

Wichtige Aspekte bei der Konstruktion einer Kühlvorrichtung eines Computerbauteils sind neben optimaler Kühlung auch kostengünstige Herstellung und geringer Platzbedarf im Computergehäuse. Als sehr kostengünstig erweist es sich, wenn die selbe Kühlvorrichtung für unterschliedliche Computermodelle genutzt werden kann, da sie dann in größerer Stückzahl produziert werden kann.

Um den unterschiedlichen Computermodellen gerecht zu werden ist eine flexible Kühlvorrichtung von Vorteil. Dies kann durch eine bewegliche Kühlluftführung realisiert werden.

Eine derartige Kühlluftführung ist bereits aus der noch nicht veröffentlichten Druckschrift DE 101 313 68.3 bekannt.

Diese Kühlluftführung besteht im wesentlichen aus drei Teilen, einem starren Teil, das an der Stromversorgung befestigt wird, einem starren Teil, das an dem Prozessor befestigt wird, und einem flexiblen Teil, welches die starren Teile miteinander verbindet.

Das flexible Teil ist als Folienscharnier ausgebildet und erlaubt daher eine Bewegung der starren Teile zueinander in einer Dimension.

Bei unterschiedlichen Motherboards variiert die Position, an der der Prozessor aufgesteckt wird. Durch die eindimensionale Bewegungsmöglichkeit der Kühlluftführung kann somit ein und dieselbe Kühlluftführung für unterschiedliche Motherboards verwendet werden, bei denen die Position des Prozessors nur gering und in einer Dimension variiert.

Ein Nachteil dieser Ausführungsform besteht darin, daß oberhalb der Folienscharniere die Kühlluftführung nicht komplett geschlossen ist und somit die Effizienz etwas reduziert ist.

Bei anderen bekannten Kühlluftführungen wird zwischen dem Teil, das an der Kühlung befestigt ist, und dem Bauteil, das an dem Prozessor befestigt ist, ein flexibler Schlauch befestigt, durch welchen die Kühlluftführung in alle drei Raumrichtungen beweglich ist und somit auch die unterschiedlichsten Positionen des Prozessors auf dem Motherboard erreichbar sind.

Das Problem hierbei ist, daß der Querschnitt eines Schlauches oft nicht ausreicht, um die nötige Kühlluft genügend schnell vom wärmeerzeugenden Bauteil zur Kühlung zu transportieren und dieser darüber hinaus ein zu großer Kostenfaktor darstellt.

Der Erfindung liegt daher die Aufgabe zugrunde, die gattungsgemäße Kühlluftführung derart weiterzubilden, daß die Effizienz und der Einsatzbereich vergrößert wird.

Die Aufgabe wird erfindungsgemäß dadurch gelöst, daß das bewegliche Element im Querschnitt U-förmig ist.

Das bewegliche Element verbindet eine Haube, die über den Prozessor gestülpt wird, direkt oder indirekt mit der Kühlvorrichtung. Vorzugsweise ist es in alle drei Raumrichtungen beweglich, wobei die Größe des Querschnitts nicht durch das bewegliche Element begrenzt wird.

Das bewegliche Element ist geschlossen U-förmig, so daß keine Verlustströmungen entstehen und die Bewegung in allen drei Raumrichtungen möglich ist.

Weitere Einzelheiten und Ausgestaltungen der Erfindung sind in den Unteransprüchen angegeben.

Die Erfindung wird nachfolgend an einem Ausführungsbeispiel anhand der Zeichnungen näher erläutert.

In den Zeichnungen zeigen:
- Figur 1: eine einzelne Kühlluftführung,
- Figur 2: eine Kühlluftführung, die in einen Computer eingebaut ist.

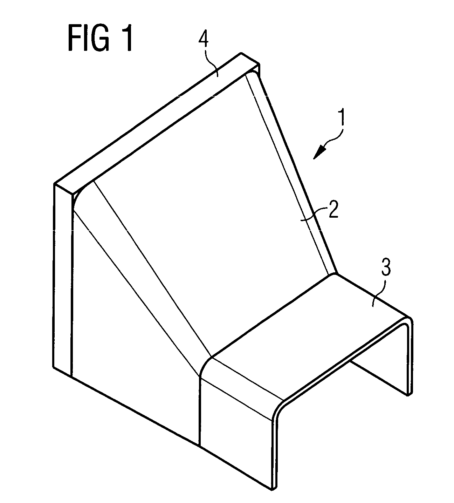

Figur 1 zeigt die Schrägansicht einer Kühlluftführung 1, welche im wesentlichen aus drei Teilen besteht, einem Anschluß 4, welcher einen Kühlluftein- bzw. Kühlluftauslaß mit der Kühlluftführung 1 verbindet, einem U-förmigen beweglichem Element 2 und einer Haube 3.

Die Haube 3, die über einen Mikroprozessor gestülpt wird, weist ebenfalls einen U-förmigen Querschnitt auf. Zwischen dem Anschluß 4 und der Haube 3 befindet sich ein bewegliches Element 2, welches auf der einen Seite dem U-förmigen Querschnitt der Haube entspricht und auf der anderen Seite dem U-förmigen Querschnitt des Anschlusses 4.

Das bewegliche Element 2 ist aus einem flexiblen Material gebildet, welches einerseits Bewegungen in alle drei Raumrichtungen erlaubt und andererseits eine optimale Anpassung an ein Motherboard ermöglicht.

Die einzelnen Bauteile sind nur über Schweißnähte miteinander verbunden. Zusätzliche Verbindungselemente sind nicht nötig.

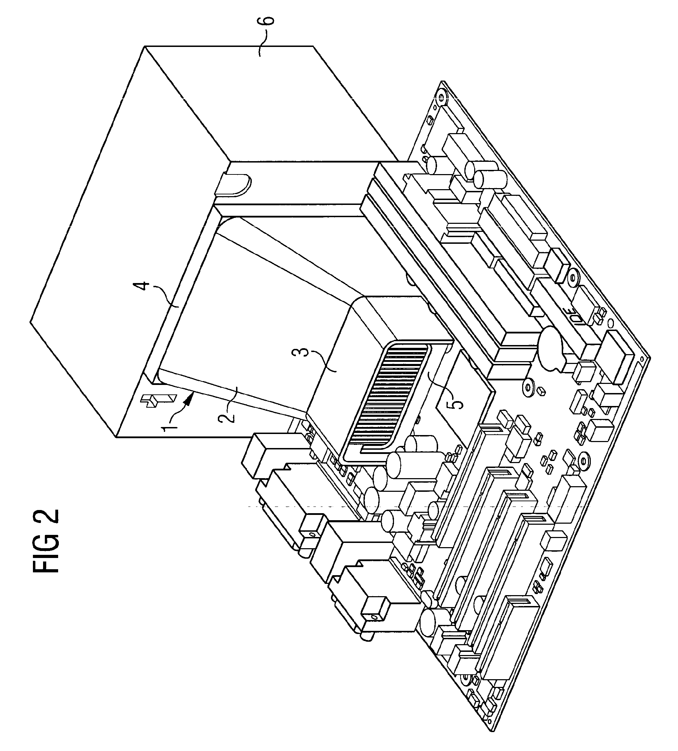

Figur 2 zeigt die Kühlluftführung 1, wie sie in einen Computer eingebaut ist.

Der Anschluß 4 ist an einen Lüfter einer Stromversorgung 6 angeschlossen. Die Haube 3 ist über dem Mikroprozessor befestigt. Das bewegliche Element 2 verbindet den Anschluß 4 mit der Haube 3.

Die Haube 3 ist wie das bewegliche Element aus flexiblem Material gebildet. So kann der Prozessor relativ luftdicht umschloßen werden, damit die erwärmte Luft nicht in das Computergehäuse entweichen kann, sondern über das bewegliche Element 2 zum Lüfter der Stromversorgung 6 geleitet wird.

Das bewegliche Element 2 kann auch nach dem Balgenprinzip ausgebildet sein.

### Bezugszeichenliste

- 1: Kühlluftführung
- 2: bewegliches Element
- 3: Haube
- 4: Anschluß
- 5: wärmeerzeugendes Bauteil
- 6: Stromversorgung

## Patentansprüche

1. Kühlluftführung (1) in einem Computer zur Kühlung eines wärmeerzeugenden Bauteils (5), wie einem Prozessor, welche Kühlluft zwischen einem Kühlluftein- bzw. -auslaß über ein bewegliches Element (2) zu dem wärmeerzeugenden Bauteil (5) leitet,
**dadurch gekennzeichnet, daß**
das bewegliche Element im Querschnitt U-förmig ist.

2. Kühlluftführung nach Anspruch 1,
**dadurch gekennzeichnet, daß**
das bewegliche Element (2) in alle drei Raumrichtungen bewegbar ist.

3. Kühlluftführung nach Anspruch 1 oder 2,
**dadurch gekennzeichnet, daß**
das bewegliche Element (2) nach dem Balgenprinzip gebildet ist.

4. Kühlluftführung nach Anspruch 1 bis 3,
**dadurch gekennzeichnet, daß**
das bewegliche Element aus einem flexiblen Material gebildet ist.

5. Kühlluftführung nach Anspruch 1 bis 4,
**dadurch gekennzeichnet, daß**
die Kühlluftführung (1) aus im wesentlichen einem Anschlußteil (4), einem beweglichen Element (2) und einer Haube (3) gebildet ist.

6. Kühlluftführung nach Anspruch 1 bis 4,
**dadurch gekennzeichnet, daß**
die Kühlluftführung einstückig ausgebildet ist.

7. Kühlluftführung nach Anspruch 1 bis 4,
**dadurch gekennzeichnet, daß**
das bewegliche Element (2) direkt an dem Kühlluftein- bzw. Kühlluftauslaß befestigt ist.

8. Kühlluftführung nach Anspruch 1 bis 5,
**dadurch gekennzeichnet, daß**
die Haube (3) aus einem flexiblen Material gebildet ist.
